(19) Europäisches Patentamt
European Patent Office
Office européen des brevets

(11) **EP 3 014 288 B1**

(12) **EUROPEAN PATENT SPECIFICATION**

(45) Date of publication and mention
of the grant of the patent:
**05.08.2020 Bulletin 2020/32**

(51) Int Cl.:
*G01R 19/165* (2006.01)   *G06F 1/16* (2006.01)
*G06F 1/32* (2019.01)

(21) Application number: **13887623.0**

(22) Date of filing: **28.06.2013**

(86) International application number:
**PCT/US2013/048774**

(87) International publication number:
**WO 2014/209397 (31.12.2014 Gazette 2014/53)**

(54) **A POWER DETECTOR CIRCUIT**

STROMDETEKTORSCHALTUNG

CIRCUIT DÉTECTEUR D'ÉNERGIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**04.05.2016 Bulletin 2016/18**

(73) Proprietor: **Intel Corporation
Santa Clara, CA 95054 (US)**

(72) Inventors:
• **HAIDER, Nazar
Fremont, California 94539 (US)**
• **RUSTAM, Hendra
Santa Clara, California 95051 (US)**
• **SINGH, Guneet
Santa Clara, California 95054 (US)**

(74) Representative: **HGF
1 City Walk
Leeds LS11 9DX (GB)**

(56) References cited:
GB-B- 2 014 019          JP-A- H03 279 866
JP-A- H09 289 495        KR-A- 20100 078 757
US-A1- 2004 003 301      US-A1- 2004 049 704
US-A1- 2004 133 816      US-A1- 2010 191 985
US-A1- 2010 229 021      US-A1- 2011 126 056
US-A1- 2012 166 854      US-A1- 2012 194 141
US-B1- 7 596 708

## Description

## BACKGROUND

The number of cores has rapidly increased for each new generation of servers, thanks to a constantly growing need for improved server performance. However, the total power envelope for each generation of servers has not changed. Power management is used to control and reduce power usage so that the server delivers optimal performance and the power supply does not get overloaded.

Reference is made to US 2004/003301A1, which discloses methods and apparatus for controlling processor performance to regulate heat generation.

For example, a power monitor is provided for use in a computer having a processor. The example power monitor includes a current sense resistor associated with a power input of the processor and an amplifier in communication with the current sense resistor to develop a signal representative of power dissipated by the processor. The power monitor also includes a comparison circuit to compare the signal output by the amplifier with a predetermined threshold.

US 2004/0133816 A1 discloses a system for performing power saving control in which a current flowing through an electrical path is detected as a voltage and the voltage is amplified and outputted. When the outputted voltage exceeds a power limit, a power limit detection signal is output and upon receipt of the power limit detection signal, throttling of a clock frequency of the Central Processing Unit (CPU) is performed.

Japanese patent application publication number JP H09 289495 A by Matsushita Electric Ind Co Ltd. Discloses an amplifier and an optical receiving circuit that uses a signal generated by the amplifier. Two identical maximum value holding circuits are provided between a first differential amplifier and outputs of the maximum value holding circuits are input to a second differential amplifier. Output variations generated by the two maximum value holding circuits owing to temperature variation are cancelled by the second differential amplifier. A third differential amplifier receives as inputs both an output of the first differential amplifier and an output of the second differential amplifier. The third differential amplifier accurately follows a DC level of the signal input.

US 2012/0194141 A1 discloses voltage detection by selectably voltage sensing the voltage of a rechargeable battery or current sensing a current flowing through the rechargeable battery.

US 2004/049704 A1 discloses an apparatus for dynamically adjusting a power consumption of a CPU of a computer system. A current flowing through a limiting resistor is detected and compared with a predetermined current and a warning signal is issued when the detected current is larger than the predetermined value. Responsive to the warning signal an asynchronous frequency reduction instruction is sent to the CPU.

The scope of protection sought for the present invention is defined by the appended independent claims and optional features are defined by the appended dependent claims.

## BRIEF DESCRIPTION OF THE FIGURES

The following detailed description may be better understood by referencing the accompanying drawings, which contain specific examples of numerous objects and features of the disclosed subject matter.

Fig. 1 is a block diagram of a system for power management and delivery in an electronic device.
Fig. 2 is a graph illustrating the relationship between voltage and current in a power detector circuit.
Fig. 3 is a graph illustrating sensed voltage levels in a power detector circuit for various server platform configurations.
Fig. 4 is a diagram of an embodiment of a power detector circuit.
Fig. 5 is a diagram of an embodiment of a power detector circuit.
Fig. 6 is a diagram of an embodiment of a power detector circuit.
Fig. 7 is a diagram of an embodiment of a power detector circuit.
Fig. 8 is a diagram of an embodiment of a power detector circuit.
Fig. 9 is a process flow diagram of a method for detecting maximum power usage.

## DETAILED DESCRIPTION

The present disclosure is related to thermal management and platform level power management and delivery in an electronic device. Thermal design power (TDP) represents the amount of power dissipated when a CPU is running at its nominal frequency while running the highest power real world application. Maximum application power ($P_{app}$) represents the maximum amount of power dissipated when the CPU is running non-virus applications, which can occur when the CPU is overclocked or in Turbo. Maximum power ($P_{max}$) is a power specification that refers to the absolute maximum power dissipated by the CPU during operation. A power virus is a malicious computer program that is coded to maximize CPU power dissipation (or thermal energy output), causing the electronic device to overheat over time. A power virus can cause the CPU to operate at $P_{max}$. $P_{max}$ can be several times greater than TDP, and may be substantially greater than $P_{app}$. $P_{max}$ is not sustainable by the server platform's power supply.

With each successive generation of server platform, the number of cores has increased, leading to a steep increase in $P_{max}$ in relation to TDP. As $P_{max}$ increases with each generation, so does the demand for larger power supplies and larger bulk caps on the server platform's motherboard to handle $P_{max}$ conditions. This is a trend that is not sustainable due to the real estate and infrastructure required. By improving feedback time between the server platform's power supply and CPU, the $P_{max}$ condition can be detected and remedied more quickly. As the CPU spends less time operating in $P_{max}$, the need for larger and more expensive bulk caps is reduced.

A power detector circuit in an electronic device can control the amount of power dissipated by a CPU in operation and reduce thermal output in order to prevent overheating. The power detector circuit can measure voltage at a sensing point, and determine if a certain power condition has been reached. A power condition can refer to a level of power dissipated by a central processing unit (CPU) during operation. If the power condition has been reached, the power detector circuit can send out an alert to reduce power production. By measuring voltage, the power detector circuit can provide fast feedback (within a few microseconds) that the power condition has been reached. The power detector circuit can also be adapted to be used for a number of different electronic device configurations. The power detector circuit can be used to detect when the electronic device is operating under unsustainable conditions, and take action to alleviate the unsustainable conditions.

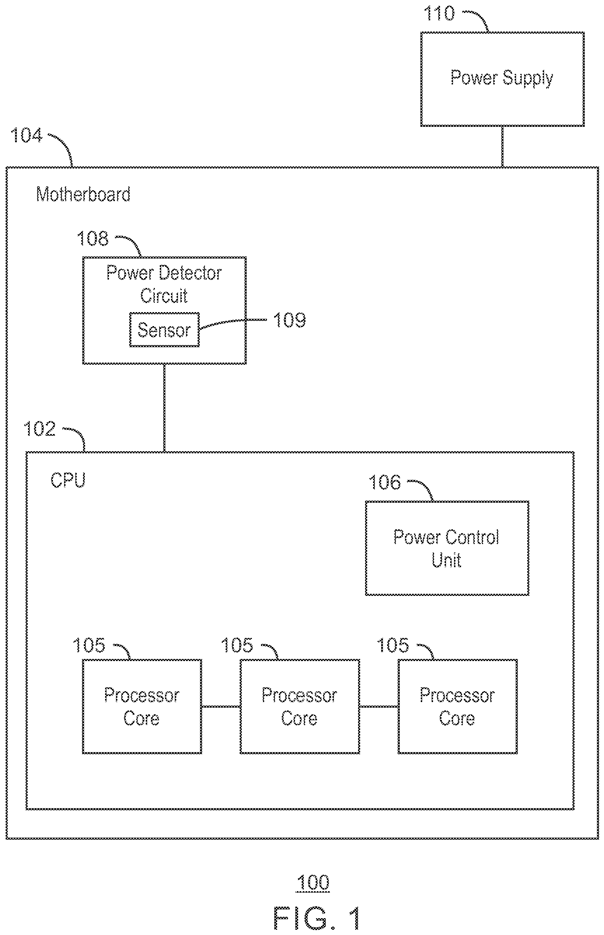

Fig. 1 is a block diagram of a system for power management and delivery in an electronic device. The system 100 can be used in an electronic device such as a server platform, a computer, a tablet, or a mobile phone. In some embodiments, the electronic device can utilize a multi-core processor.

The system 100 includes a central processing unit (CPU) 102 connected to a motherboard 104. The CPU 102 is used to run programs and applications, and may contain multiple processor cores 105. In some embodiments, the system 100 will utilize more than one CPU 102. A power control unit 106 is configured to deliver power to the one or more processor cores 102. The power control unit 106 can control the amount of power delivered to the one or more processor cores 102, and can throttle the one or more processor cores 102 in order to reduce power usage. The power control unit 106 can be coupled to or be contained in the CPU 102. A power supply 107 can deliver power to the motherboard.

A power detector circuit 108 can be coupled to the CPU 102 or the power control unit 106. The power detector circuit 108 is configured to measure how much power is being produced by the CPU 102 during operation. More specifically, a sensed voltage in the power detector circuit 108 can be measured at a sense point within the power detector circuit 108. In some embodiments, the sense point can be a sensor 109. If the sensed voltage is less than a pre-determined threshold, then the power detector circuit 108 can determine that a certain power condition has been detected. When the power condition has been detected, the power detector circuit 108 can send an alert to the power control unit 106, and command the power control unit 106 to throttle the one or more processor cores 102 to reduce power production.

The power condition can occur when a threshold of power produced is reached. In some embodiments, the threshold can be $P_{max}$, the maximum amount of power produced while a processor core 102 is running a power virus. In some embodiments, a user can set the threshold at a particular level, e.g. $P_{app}$.

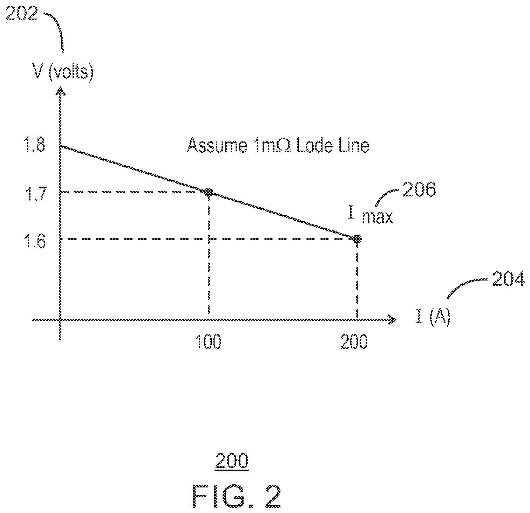

Fig. 2 is a graph illustrating the relationship between voltage and current in a power detector circuit. As is seen in the graph 200, the voltage 202 is proportional to the current 204. The current 204 can be supplied from a voltage regulator to a loadline in a circuit. The current 204 can represent the amount of power produced during CPU operation. $I_{max}$ 206 represents the current at $P_{max}$, the maximum amount of power produced while a CPU is running a power virus.

In one example, the loadline of Fig. 2 has a resistance of 1 m$\Omega$. A motherboard voltage regulator provides a nominal voltage of 1.8 V, which is the voltage of the loadline when no current is present. When the current is at $I_{max}$ (200 A), the voltage in the loadline is 1.6 V.

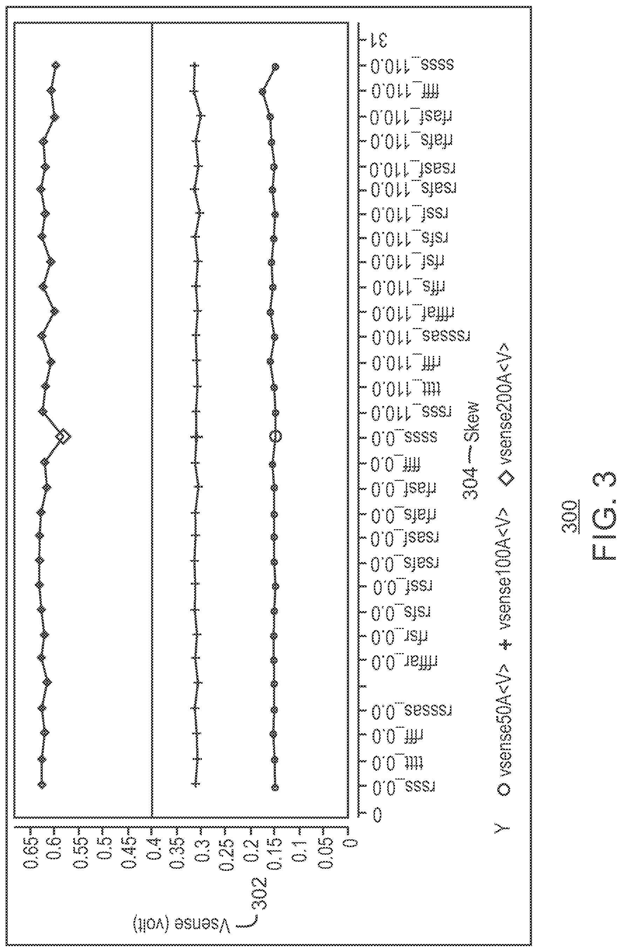

Fig. 3 is a graph illustrating sensed voltage levels in a power detector circuit for various server platform configurations. The graph 300 displays the voltage sensed 302 for platform configurations, also known as skews, at three different current levels using a power detecting circuit. Each skew 604 is represented by a series of letters that indicate characteristics of the server platform's components, and a number that represents operating temperature. Each component of the server platform may be realistic (indicated by "r"), typical ("t"), slow ("s"), or fast ("f"). For example, "typical" represents a CPU part that consists of transistors and interconnects which are deemed typical for the process technology that the CPU is manufactured with. The operating temperature may be between 0° C and 110°C. For example, the skew "rsss_0.0" indicates a realistic server platform with a slow P transistor, a slow N transistor, a slow processor, and an operating temperature of 0° C.

It is to be noted that the sensed voltage readings 302 at each current level is relatively consistent across the different skews 304. This indicates that the power detecting circuit 108 may be used adaptable for different configurations.

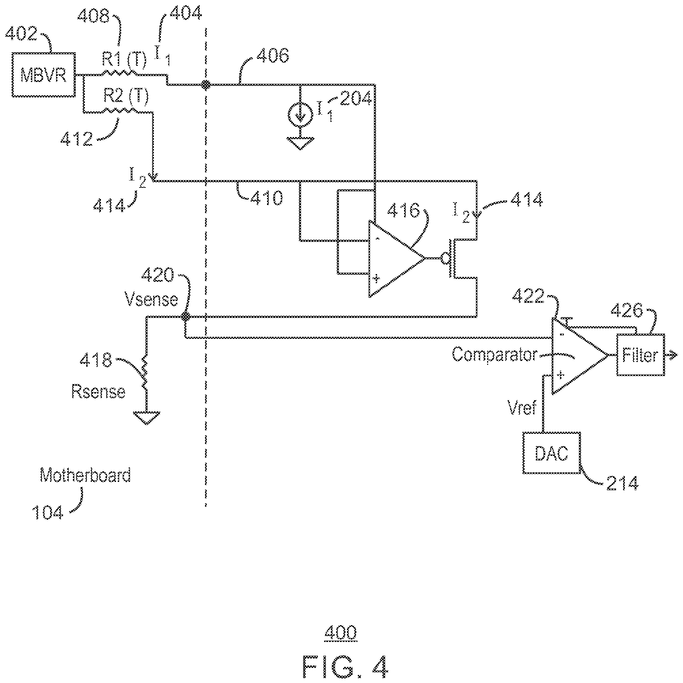

Fig. 4 is a diagram of an embodiment of a power detector circuit. The power detector circuit 400, which is an example of the power detector circuit 108 shown in Fig. 1, can monitor power production and notify a power control unit 106 if a certain power condition has been reached. The power detector circuit 400 is configured for current mode sensing. In current mode sensing, a motherboard voltage regulator (MBVR) 402 supplies currents to a pair of circuit lines in order to cancel out temperature-related variance in the resistance of the circuit lines.

The MBVR 402 coupled to a motherboard 104 supplies a first current ($I_1$) 404 to a loadline 406 with a first resistor ($R_1(T)$) 408. The loadline 406 can represent connection from the MBVR to a CPU 102 in which the first current 404 is provided. The resistance value of the first resistor 408 may vary depending on temperature. A second line 410 with a second resistor ($R_2(T)$) 412 can be coupled to the loadline 406, such that a second current ($I_2$) 414 travels along the second line 410. The resistance value of the second resistor 412 may also vary depending on temperature. The first resistor 408 and the second resistor 412 may be in close thermal proximity of one another, such that they both experience proportionally similar changes in resistance.

The loadline 406 and the second line 410 are coupled to an amplifier 416. The amplifier 416 can be used to force the voltage across the first resistor 408 and the voltage across the second resistor 412 to be equal. The loadline 406 can be connected to the positive input of the amplifier 416, and the second line 410 can be coupled to the negative input of the amplifier 416. The amplifier 416 can be a low offset amplifier.

The output of the amplifier 416 is coupled to a precision resistor ($R_{sense}$) 418, which may be coupled to the motherboard 104. The sensed voltage ($V_{sense}$) across the precision resistor 218 can be measured by the power detector circuit 200 at a sense point 420 nearby. The sense point 420 is connected to an input of a comparator 422. The other input is connected to a digital-to-analog converter (DAC) 424, which is configured to provide a reference voltage ($V_{ref}$) to the comparator 422. The reference voltage may be the voltage level in which maximum power ($P_{max}$) occurs. The reference voltage may also be a user-defined voltage level. The DAC 424 can be coupled to the motherboard 104 or the power control unit 106.

The comparator 422 can compare the sensed voltage to the reference voltage. A filter 426 coupled to the output of the comparator 422 can detect if the sensed voltage falls below the reference voltage for a sustained amount of time. If the sensed voltage does fall below the reference voltage for a sustained amount of time, the power detector circuit 400 can send an alert to the power control unit 106 that a power condition has been reached, and command the power control unit 106 to throttle or slow down operation in one or more processor cores 102.

From the measured value of the sensed voltage and the known values of the resistors, the value of the first current can ultimately be calculated. The sensed voltage at the precision resistor 418 is caused by the second current 414. Therefore, the value of the second current 418 can be determined by in the following equation:

$$V_{sense} = I_2 R_{sense}$$

The amplifier 416 forces the voltage across the first resistor 408 and the voltage across the second resistor 412 to be equal. Thus, any change in resistance in the first resistor 408 due to temperature is effectively canceled out due to a proportionally equal change in resistance in the second resistor 412. Therefore, the value of the first current can be determined in the following equation:

$$I_1 R_1 = I_2 R_2$$

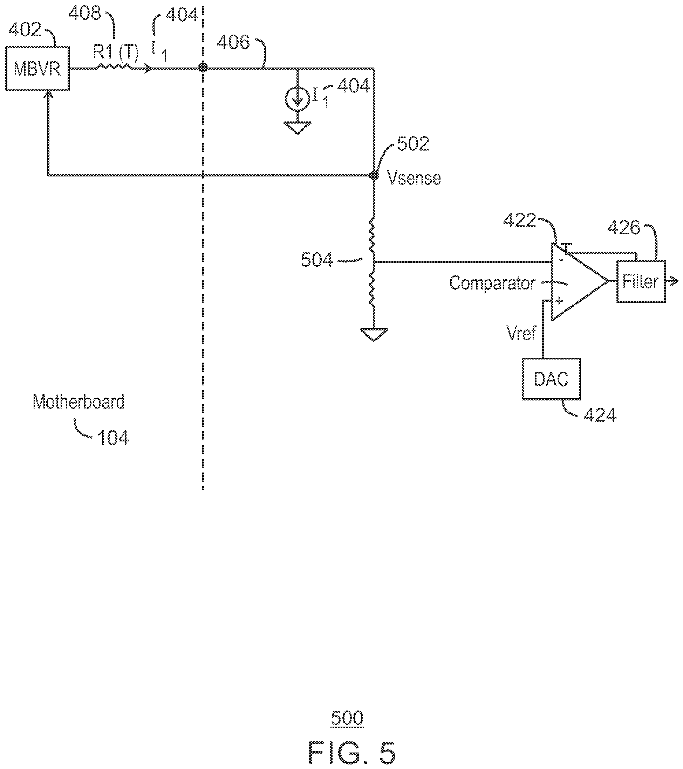

Fig. 5 is a diagram of an embodiment of a power detector circuit. The power detector circuit 500, which is an example of the power detector circuit 108 shown in Fig. 1, can be configured to power production and notify a power control unit if a certain power condition has been reached. The power detector circuit is configured for voltage mode sensing. In voltage mode sensing, a motherboard voltage regulator (MBVR) 402 is used to cancel out temperature-related variance in a circuit line.

The MBVR 402 coupled to a motherboard 104 supplies a first current ($I_1$) 404 to a loadline 406 with a first resistor ($R_1(T)$) 408. The loadline 406 can represent connection from the MBVR to a CPU 102 in which the first current 404 is provided. The resistance value of the first resistor 408 may vary depending on temperature. The loadline 406 may loop back to the MBVR 402, allowing the MBVR 402 to regulate and cancel any temperature-related changes in the resistance of the first resistor 408.

The sensed voltage ($V_{sense}$) along the loadline 406 can be measured at a sense point 502. The sense point 502 is connected to an input of a comparator 422. The other input is connected to a digital-to-analog converter (DAC) 424, which is configured to provide a reference voltage ($V_{ref}$) to the comparator 422. The reference voltage may be the voltage level in which maximum power ($P_{max}$) occurs. The reference voltage may also be a user-defined voltage level. The DAC 424 can be coupled to the motherboard 104 or the power control unit 106.

The comparator 422 can compare the sensed voltage to the reference voltage. A filter 426 coupled to the output of the comparator 422 can detect if the sensed voltage falls below the reference voltage for a sustained amount of time. If the sensed voltage does fall below the reference voltage for a sustained amount of time, the power detector circuit 400 can send an alert to the power control unit 106 that a power condition has been reached, and command the power control unit 106 to throttle or slow down operation in one or more processor cores 102.

In some embodiments, the comparator 422 may not be able to accept a high voltage. Thus, the sensed voltage may be reduced using a voltage divider 504 at the sense point 502. The voltage divider 504 may be a resistive divider, a low-pass RC filter, an inductive divider, or a capacitive divider. Accordingly, the reference voltage can be scaled down with the voltage ratio of the voltage divider 504.

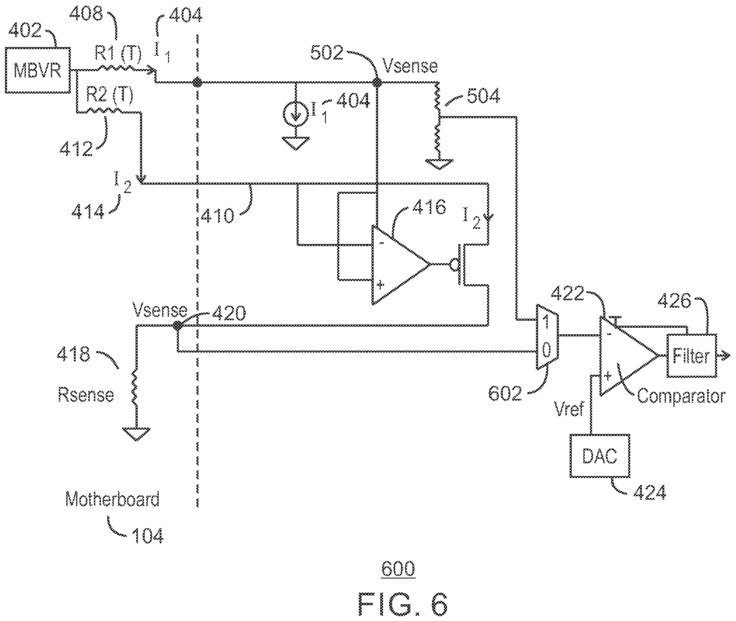

Fig. 6 is a diagram of an embodiment of a power detector circuit. The power detector circuit 600, which is an example of the power detector circuit 108 shown in Fig. 1, can be configured to power production and notify a power control unit if a certain power condition has been reached. The power detector circuit is configured to switch between current mode sensing and voltage mode sensing.

The power detector circuit 600 includes components shown in the circuits illustrated Figs. 4 and 5, along with a switch 602 that allows the power detector circuit 600 to change between the circuit configured for current mode sensing (Fig. 4) and the circuit configured for voltage mode sensing (Fig. 5).

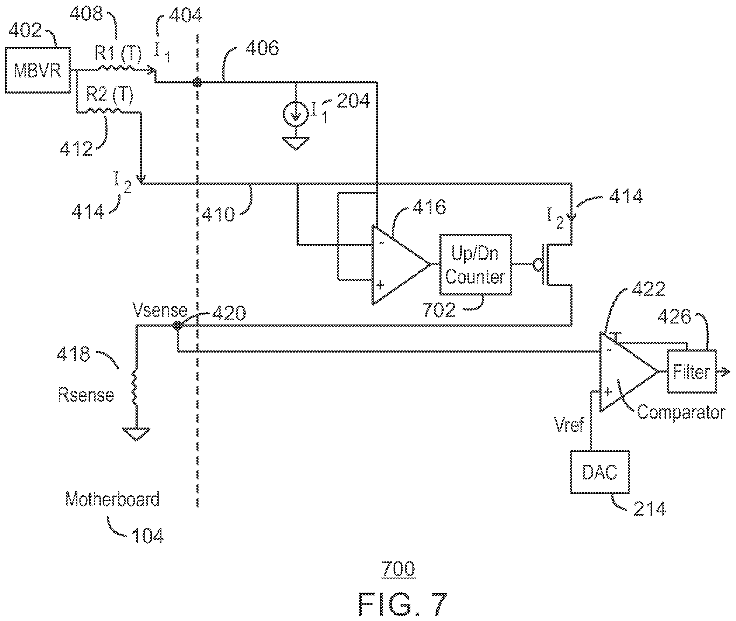

Fig. 7 is a diagram of an embodiment of a power detector circuit. The power detector circuit 700, which is an example of the power detector circuit 108 shown in Fig. 1, can monitor power production and notify a power control unit 106 if a certain power condition has been reached. The power detector circuit 700 is configured for current mode sensing. In current mode sensing, a motherboard voltage regulator (MBVR) 402 supplies currents to a pair of circuit lines in order to cancel out temperature-related variance in the resistance of the circuit lines.

The power detector circuit 700 includes components shown in the circuit illustrated in Fig. 4. The power detector circuit further includes an up/down counter 702 coupled to the output of the amplifier 416. The up/down counter 702 can compare the voltage from the loadline 406 (referred to herein as $V_1$) to the voltage from the second line 410 (referred to herein as $V_2$). If $V_2$ is greater than $V_1$, the up/down counter 702 can count down in response, and enable transistors to increase the second current $I_2$ 414 such that the value of $V_2$ is incrementally reduced to be equal to $V_1$. If $V_2$ is less than $V_1$, the up/down counter 702 can count up in response, and disable transistors to decrease the second current $I_2$ 414 such that the value of $V_2$ is incrementally increased to be equal to $V_1$.

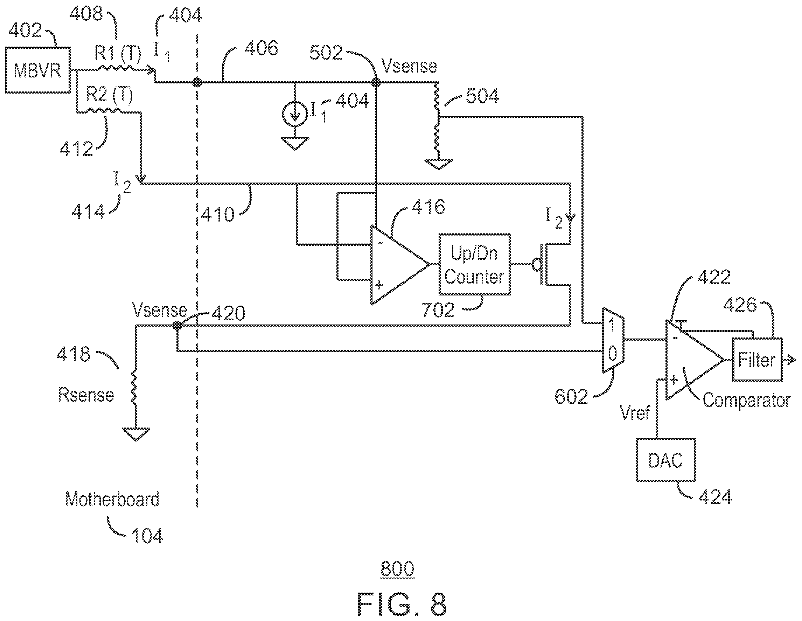

Fig. 8 is a diagram of an embodiment of a power detector circuit. The power detector circuit 800, which is an example of the power detector circuit 108 shown in Fig. 1, can monitor power production and notify a power control unit 106 if a certain power condition has been reached. The power detector circuit 800 is configured to switch between current mode sensing and voltage mode sensing.

The power detector circuit 800 includes components shown in the circuit illustrated in Fig. 6. The power detector circuit further includes an up/down counter 702 coupled to the output of the amplifier 416. The up/down counter 702 can compare the voltage from the loadline 406 (referred to herein as $V_1$) to the voltage from the second line 410 (referred to herein as $V_2$). If $V_2$ is greater than $V_1$, the up/down counter 702 can count down in response, and enable transistors to increase the second current $I_2$ 414 such that the value of $V_2$ is incrementally reduced to be equal to $V_1$. If $V_2$ is less than $V_1$, the up/down counter 702 can count up in response, and disable transistors to decrease the second current $I_2$ 414 such that the value of $V_2$ is incrementally increased to be equal to $V_1$.

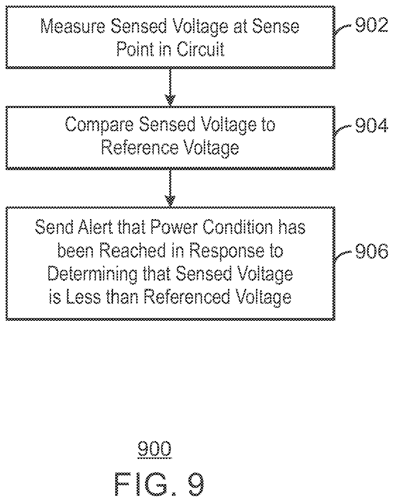

Fig. 9 is a process flow diagram of a method for detecting maximum power usage. The method 900 can be performed by a circuit in an electronic device. At block 902, the circuit determines a sensed voltage at a precision resistor. At block 904, the circuit compares the sensed voltage to a reference voltage. At block 906, the circuit sends an alert that a power condition has been reached in response to determining that the sensed voltage is less than the reference voltage.

Although some embodiments have been described in reference to particular implementations, other implementations are possible according to some embodiments. Additionally, the arrangement and order of circuit elements or other features illustrated in the drawings or described herein need not be arranged in the particular way illustrated and described. Many other arrangements are possible according to some embodiments.

In each system shown in a figure, the elements in some cases may each have a same reference number or a different reference number to suggest that the elements represented could be different or similar. However, an element may be flexible enough to have different implementations and work with some or all of the systems shown or described herein. The various elements shown in the figures may be the same or different. Which one is referred to as a first element and which is called a second element is arbitrary.

In the description and claims, the terms "coupled" and "connected," along with their derivatives, may be used. It should be understood that these terms are not intended as synonyms for each other. Rather, in particular embodiments, "connected" may be used to indicate that two or more elements are in direct physical or electrical contact with each other. "Coupled" may mean that two or more elements are in direct physical or electrical contact. However, "coupled" may also mean that two or more elements are not in direct contact with each other, but yet still co-operate or interact with each other.

An embodiment is an implementation or example of the inventions. Reference in the specification to "an embodiment," "one embodiment," "some embodiments," or "other embodiments" means that a particular feature, structure, or characteristic described in connection with the embodiments is included in at least some embodiments, but not necessarily all embodiments, of the inventions. The various appearances "an embodiment," "one embodiment," or "some embodiments" are not necessarily all referring to the same embodiments.

Not all components, features, structures, characteristics, etc. described and illustrated herein need be included in a particular embodiment or embodiments. If the specification states a component, feature, structure, or characteristic "may", "might", "can" or "could" be included, for example, that particular component, feature, structure, or characteristic is not required to be included. If the specification or claim refers to "a" or "an" element, that does not mean there is only one of the element. If the specification or claims refer to "an additional" element, that does not preclude there being more than one of the additional element.

Although flow diagrams and state diagrams may have been used herein to describe embodiments, the inventions are not limited to those diagrams or to corresponding descriptions herein. For example, flow need not move through each illustrated box or state or in exactly the same order as illustrated and described herein.

The inventions are not restricted to the particular details listed herein. Indeed, those skilled in the art having the benefit of this disclosure will appreciate that many other variations from the foregoing description and drawings may be made within the scope of the present inventions. Accordingly, it is the following claims including any amendments thereto that define the scope of the inventions.

**Claims**

1. A circuit for managing power and heat of a Central Processing Unit, comprising:

    a motherboard voltage regulator (402) to supply a current to a loadline (406);
    a sense point (502) coupled to the loadline, the circuit to measure a sensed voltage at the sense point;
    a comparator (422) to compare the sensed voltage to a reference voltage, an output of the comparator to indicate a level of current being provided by the motherboard voltage regulator; a second line (410) coupled to the motherboard voltage regulator;
    a precision resistor (418) at the sense point;
    an amplifier (416) to cancel out temperature-related variation in the resistance of the loadline by controlling a transistor coupled to an output of the amplifier to increase or decrease a current in the second line, wherein the loadline and the second line are each coupled to an input of the amplifier, and the precision resistor is coupled to the transistor; and a switch (602) to change between voltage mode sensing and current mode sensing.

2. The circuit of claim 1, comprising a voltage divider (504) at the sense point.

3. The circuit of claims 1 or 2, comprising a digital-to-analog converter 'DAC' (424) coupled to an input of the comparator, the DAC to provide a value of the reference voltage.

4. The circuit of any preceding claim, wherein the loadline provides power from the motherboard voltage regulator to a plurality of processor cores (105) of the CPU.

5. The circuit of claim 4, wherein the value of the reference voltage is set such that if the sensed voltage drops below the reference voltage it indicates that a power virus is executing on one or more of the plurality of processor cores.

6. The circuit of any one claims 1 to 4, wherein the reference voltage is an absolute maximum power, $P_{max}$, dissipated by the CPU and wherein comparator is to sense from the comparison that the CPU is operating under unsustainable power conditions.

7. The circuit of any one of the preceding claims wherein the reference voltage level is a user-defined voltage level.

8. The circuit of any one of the preceding claims, comprising an up/down counter coupled to an output of the amplifier, the up/down counter being configured to compare a voltage of the loadline to a voltage of the second line and to incrementally reduce any difference between the voltage of the loadline and the voltage of the second line.

9. The circuit of claim 1 comprising a filter (426) coupled to the output of the comparator, the filter to detect when the sensed voltage is less than the reference voltage for a sustained period of time and wherein the filter detection is to cause a power control unit of the CPU to throttle of one or more processor cores of the CPU.

10. The circuit of claim 1 comprising an up/down counter (702) coupled to an output of the amplifier (416) and to an input of the transistor, the up/down counter (702) to compare a voltage from the loadline to a voltage from the second line.

11. An electronic device (100) for managing power and heat, comprising:

    a motherboard (104);
    a processor core (105) coupled to the motherboard;
    a circuit (106) according to any preceding claim coupled to the motherboard and the processor core.

**Patentansprüche**

1. Schaltung zum Verwalten von Leistung und Wärme an einer zentralen Verarbeitungseinheit, umfassend:

    einen Hauptplatinen-Spannungsregler (402) zum Zuführen eines Stroms zu einer Lastleitung (406);

einen Erfassungspunkt (502), gekoppelt an die Lastleitung, wobei die Schaltung eine erfasste Spannung an dem Erfassungspunkt messen soll;

einen Komparator (422) zum Vergleichen der erfassten Spannung mit einer Referenzspannung, wobei ein Ausgang des Komparators einen Strompegel, der durch den Hauptplatinen-Spannungsregler bereitgestellt wird, angeben soll; eine zweite Leitung (410), gekoppelt an den Hauptplatinen-Spannungsregler;

einen Präzisionswiderstand (418) an dem Erfassungspunkt;

einen Verstärker (416) zum Auslöschen einer temperaturbezogenen Variation in dem Widerstand der Lastleitung durch Steuern eines an einen Ausgang des Verstärkers gekoppelten Transistors zum Erhöhen oder Verringern eines Stroms in der zweiten Leitung, wobei die Lastleitung und die zweite Leitung an einen Eingang des Verstärkers gekoppelt sind und der Präzisionswiderstand an den Transistor gekoppelt ist; und einen Schalter (602) zum Wechseln zwischen Spannungsmoduserfassung und Strommoduserfassung.

2. Schaltung nach Anspruch 1, umfassend einen Spannungsteiler (504) an dem Erfassungspunkt.

3. Schaltung nach Anspruch 1 oder 2, umfassend einen Digital-zu-Analog-Wandler "DAC" (424), gekoppelt an einen Eingang des Komparators, wobei der DAC einen Wert der Referenzspannung bereitstellen soll.

4. Schaltung nach einem der vorstehenden Ansprüche, wobei die Lastleitung Leistung von dem Hauptplatinen-Spannungsregler zu einer Vielzahl von Prozessorkernen (105) der CPU bereitstellt.

5. Schaltung nach Anspruch 4, wobei der Wert der Referenzspannung derart gesetzt wird, dass, wenn die erfasste Spannung unter die Referenzspannung fällt, er angibt, dass ein Leistungsvirus in einem oder mehreren der Vielzahl von Prozessorkernen ausgeführt wird.

6. Schaltung nach einem der Ansprüche 1 bis 4, wobei die Referenzspannung eine absolute Maximalleistung, $P_{max}$, ist, die durch die CPU abgeleitet wird, und wobei der Komparator aus dem Vergleich erfassen soll, dass die CPU unter nicht aufrechtzuerhaltenden Leistungsbedingungen betrieben wird.

7. Schaltung nach einem der vorstehenden Ansprüche, wobei der Referenzspannungspegel ein durch einen Benutzer definierter Spannungspegel ist.

8. Schaltung nach einem der vorstehenden Ansprüche, umfassend einen Aufwärts-/Abwärtszähler, gekoppelt an einen Ausgang des Verstärkers, wobei der Aufwärts-/Abwärtszähler konfiguriert ist, eine Spannung der Lastleitung mit einer Spannung der zweiten Leitung zu vergleichen und eine etwaige Differenz zwischen der Spannung der Lastleitung und der Spannung der zweiten Leitung inkrementell zu reduzieren.

9. Schaltung nach Anspruch 1, umfassend ein Filter (426), gekoppelt an den Ausgang des Komparators, wobei das Filter detektieren soll, wenn die erfasste Spannung über einen anhaltenden Zeitraum kleiner als die Referenzspannung ist, und wobei die Filterdetektion bewirken soll, dass eine Leistungssteuereinheit der CPU einen oder mehrere Prozessorkerne der CPU drosselt.

10. Schaltung nach Anspruch 1, umfassend einen Aufwärts-/Abwärtszähler (702), gekoppelt an einen Ausgang des Verstärkers (416) und an einen Eingang des Transistors, wobei der Aufwärts-/Abwärtszähler (702) eine Spannung von der Lastleitung mit einer Spannung von der zweiten Leitung vergleichen soll.

11. Elektronische Vorrichtung (100) zum Verwalten von Leistung und Wärme, umfassend:

eine Hauptplatine (104);
einen Prozessorkern (105), gekoppelt an die Hauptplatine;
eine Schaltung (106) nach einem der vorstehenden Ansprüche, gekoppelt an die Hauptplatine und den Prozessorkern.

**Revendications**

1. Circuit destiné à gérer la puissance et la chaleur d'une Unité centrale de traitement, comportant :

un régulateur (402) de tension de carte-mère servant à délivrer un courant à une ligne (406) de charge ;
un point (502) de détection couplé à la ligne de charge, le circuit servant à mesurer une tension détectée au point de détection ;
un comparateur (422) servant à comparer la tension détectée à une tension de référence, une sortie du comparateur servant à indiquer un niveau de courant fourni par le régulateur de tension de carte-mère ;
une deuxième ligne (410) couplée au régulateur de tension de carte-mère ;
une résistance (418) de précision au point de détection ;

un amplificateur (416) servant à annuler une variation liée à la température dans la résistance de la ligne de charge en commandant un transistor couplé à une sortie de l'amplificateur pour augmenter ou diminuer un courant dans la deuxième ligne, la ligne de charge et la deuxième ligne étant couplées chacune à une entrée de l'amplificateur, et la résistance de précision étant couplée au transistor ; et

un commutateur (602) servant à changer entre la détection en mode tension et la détection en mode courant.

2. Circuit selon la revendication 1, comportant un diviseur (504) de tension au point de détection.

3. Circuit selon les revendications 1 ou 2, comportant un convertisseur numérique-analogique 'DAC' (424) couplé à une entrée du comparateur, le DAC servant à fournir une valeur de la tension de référence.

4. Circuit selon l'une quelconque des revendications précédentes, la ligne de charge fournissant une puissance provenant du régulateur de tension de carte-mère à une pluralité de cœurs (105) de processeur du CPU.

5. Circuit selon la revendication 4, la valeur de la tension de référence étant réglée de telle façon que si la tension détectée tombe au-dessous de la tension de référence, cela indique qu'un virus de puissance s'exécute sur un ou plusieurs cœurs de la pluralité de cœurs de processeur.

6. Circuit selon l'une quelconque des revendications 1 à 4, la tension de référence étant une puissance maximale absolue, $P_{max}$, dissipée par le CPU et le comparateur servant à détecter, à partir de la comparaison, que le CPU fonctionne dans des conditions de puissance intenables.

7. Circuit selon l'une quelconque des revendications précédentes, le niveau de tension de référence étant un niveau de tension défini par l'utilisateur.

8. Circuit selon l'une quelconque des revendications précédentes, comportant un compteur-décompteur couplé à une sortie de l'amplificateur, le compteur-décompteur étant configuré pour comparer une tension de la ligne de charge à une tension de la deuxième ligne et pour réduire par incréments une éventuelle différence entre la tension de la ligne de charge et la tension de la deuxième ligne.

9. Circuit selon la revendication 1 comportant un filtre (426) couplé à la sortie du comparateur, le filtre servant à détecter lorsque la tension détectée est inférieure à la tension de référence pendant une période soutenue et la détection du filtre servant à amener une unité de commande de puissance du CPU à étrangler un ou plusieurs cœurs de processeur du CPU.

10. Circuit selon la revendication 1 comportant un compteur-décompteur (702) couplé à une sortie de l'amplificateur (416) et à une entrée du transistor, le compteur-décompteur (702) servant à comparer une tension provenant de la ligne de charge à une tension provenant de la deuxième ligne.

11. Dispositif électronique (100) destiné à gérer la puissance et la chaleur, comportant :

une carte-mère (104) ;
un cœur (105) de processeur couplé à la carte-mère ;
un circuit (106) selon l'une quelconque des revendications précédentes couplé à la carte-mère et au cœur de processeur.

110 ⌐

Power Supply

104 ⌐

Motherboard

108 ⌐

Power Detector
Circuit

Sensor ⌐ 109

102 ⌐

CPU

106 ⌐

Power Control
Unit

105 ⌐

Processor
Core

105 ⌐

Processor
Core

105 ⌐

Processor
Core

<u>100</u>

FIG. 1

FIG. 2

FIG. 3

300

402 MBVR

408 R1 (T)

404 I₁

406

204 I₁

412 R2 (T)

414 I₂

410

416

414 I₂

420 Vsense

418 Rsense

Motherboard

104

422 Comparator

426 Filter

Vref

DAC 214

400

FIG. 4

$\underline{500}$

FIG. 5

600
FIG. 6

FIG. 7

700

800

FIG. 8

```
┌─────────────────────────────────┐
│  Measure Sensed Voltage at Sense │──902
│         Point in Circuit         │
└─────────────────────────────────┘
                 │
                 ▼
┌─────────────────────────────────┐
│     Compare Sensed Voltage to    │──904
│        Reference Voltage         │
└─────────────────────────────────┘
                 │
                 ▼
┌─────────────────────────────────┐
│  Send Alert that Power Condition has │
│   been Reached in Response to    │──906
│ Determining that Sensed Voltage  │
│   is Less than Referenced Voltage │
└─────────────────────────────────┘
```

900

FIG. 9

**REFERENCES CITED IN THE DESCRIPTION**

**Patent documents cited in the description**

- US 2004003301 A1
- US 20040133816 A1
- JP H09289495 A
- US 20120194141 A1
- US 2004049704 A1